# EUROPÄISCHE PATENTSCHRIFT

(11) **EP 2 015 084 B1**
(45) Veröffentlichungstag und Bekanntmachung des Hinweises auf die Patenterteilung: **23.01.2019**
(21) Anmeldenummer: 08010847.5
(22) Anmeldetag: 14.06.2008
(51) Int. Cl.: G01R 31/00, G05B 23/02, G01R 31/319

(54) **Testvorrichtung für elektrische Komponenten**
Testing device for electric components
Dispositif de test pour composants électriques

(30) Priorität: 11.07.2007 DE 102007032627
(43) Veröffentlichungstag der Anmeldung: 14.01.2009
(73) Patentinhaber: Vector Informatik GmbH, 70499 Stuttgart (DE)
(72) Erfinder: Brinkmeyer, Horst, 71336 Waiblingen (DE); Heidenwag, Peter, 71364 Winnenden (DE); Krauss, Stefan, 70437 Stuttgart (DE); Riegraf, Thomas, 70197 Stuttgart (DE)
(74) Vertreter: Patentanwälte Bregenzer und Reule Partnerschaftsgesellschaft mbB

(56) Entgegenhaltungen:
- WO-A1-01/94930
- US-A- 5 036 479
- US-A- 5 916 287
- US-A1- 2006 282 735

## Beschreibung

Die Erfindung betrifft eine Testvorrichtung für elektrische, insbesondere elektronische, Komponenten, insbesondere eines Kraftfahrzeugs gemäß dem Oberbegriff des Anspruchs 1.

Eine derartige Testvorrichtung ist beispielsweise in US 2006/0282735 A1 erläutert.

Zum Testen elektrischer, z.B. elektronischer, Komponenten eines Kraftfahrzeuges, beispielsweise Steuergeräten, die an einen Bus des Kraftfahrzeugs angeschlossen werden, Sensoren oder dergleichen, werden üblicherweise frei verdrahtete Testanordnungen hergestellt. Die jeweilige Testanordnung ist an das zu testende Objekt angepasst. Die Komponenten werden miteinander einzeln verdrahtet und ferner mit der Testkomponente verbunden. Wenn ein Komplettsystem zu testen ist, beispielsweise ein Kraftfahrzeug-Bus mit einer Vielzahl von elektrischen Komponenten, wird die Testanordnung umfangreich und unübersichtlich. Zum Umschalten von Lasten oder Stimuli, die mit der jeweils zu testenden Komponente verbunden werden sollen, sind beispielsweise Relais-Karten üblich. Auch diese müssen individuell verdrahtet werden.

Zudem ist die Anpassung an die individuellen Testbedingungen schwierig. Beispielsweise müssen zur Erzielung gewünschter Prüfspannungen oder zur Anpassung einer Messeinrichtung an vorhandene Spannungs- oder Strompegel Anpassungseinrichtungen an die jeweilige Testanordnung angekoppelt werden. Deren Verschaltung ist kompliziert und daher fehlerträchtig.

Es ist daher die Aufgabe der vorliegenden Erfindung, eine einfach handhabbare Testvorrichtung bereitzustellen.

Zur Lösung der Aufgabe ist eine Testvorrichtung gemäß der technischen Lehre des Anspruchs 1 vorgesehen.

Ein Grundgedanke der Erfindung ist, zu Testzwecken erforderliche Ressourcen an Bord eines jeweiligen Testmoduls zu bündeln, sodass die Anzahl individueller Module, die bei der Testvorrichtung prinzipiell erforderlich sind, gering ist. Beispielsweise ist es durch die an Bord befindliche Stimulationseinrichtung bereits möglich, ein Sensor- oder ein sonstiges Eingangssignal für die zu testende Komponente zu simulieren, oder mit der Lasteinrichtung eine Last für die zu testende Komponente bereitzustellen. Mit Hilfe des Wahlschalters kann das jeweilige Stimulussignal oder die jeweilige Last auch an einen oder mehrere der Testanschlüsse geschaltet
werden. Der Wahlschalter ist über den Steueranschluss steuerbar, beispielsweise von einem Personal Computer oder einem Notebook aus.

Die interne Last kann beispielsweise eine Last von 2 bis 10.000 Ohm (10 Kilo-Ohm) sein. Vorteilhaft ist es, wenn die Last eine verhältnismäßig große Leistung aufweist, beispielsweise 10 Watt.

Ein Testmodul ist vorzugsweise mehrkanalig, das heißt, dass beispielsweise zwei oder mehrere Test-Kanäle vorhanden sind, an die jeweils eine zu testende Komponente oder unterschiedliche Ein-/Ausgänge ein und derselben zu testenden Komponente anschließbar ist.

Bei der Stimulationseinrichtung ist es vorteilhaft, wenn sie über den Steueranschluss steuerbar ist, sodass über den Steueranschluss das Stimulussignal einstellbar ist. Auf diesem Weg kann beispielsweise eine Strom- oder Spannungshöhe eingestellt werden. Auch eine Frequenz, eine Pulsform oder dergleichen des jeweiligen Stimulussignals ist zweckmäßigerweise über den Steueranschluss einstellbar. Ferner ist es vorteilhaft, wenn die Stimulationseinrichtung eine Ausgabe-Pegelanpassungseinrichtung zum Anpassen des mindestens einen Stimulussignals aufweist. Mit der Pegelanpassungseinrichtung kann beispielsweise ein niedriger Spannungs- oder Strompegel auf einen höheren Pegel gewandelt werden. Somit ist es beispielsweise möglich, von einem an sich auf Elektronik-Ebene üblichen Versorgungsniveau von 0 bis 5 Volt oder von 0 bis 10 Volt auf ein höheres und/oder niedrigeres Niveau von beispielsweise -10 bis 32 Volt zu gelangen, das für die zu testenden Komponenten erforderlich ist.

Die Stimulationseinrichtung enthält zweckmäßigerweise einen Digital-Analog-Wandler. Somit können beispielsweise über den Steueranschluss digitale Vorgabewerte eingegeben werden, die der Digital-Analog-Wandler auf analoge Werte wandelt, die ihrerseits zweckmäßigerweise von der Ausgabe-Pegelanpassungseinrichtung auf einen gewünschten Ausgabepegel (Spannung und/oder Strom) gewandelt werden.

Vorteilhaft ist ein Kurzschlussschalter bei einem oder mehreren der Testmodule, mit dem ein Kurzschluss an der Testanschlussanordnung erzeugbar ist. Der Kurzschlussschalter ist zweckmäßigerweise mit Hilfe des Wahlschalters mit der Testanschlussanordnung verbindbar. Der Kurzschlussschalter ist zweckmäßigerweise hochbelastbar und kann zumindest kurzzeitig verhältnismäßig hohe Ströme, z.B. 10 bis 20 Ampere oder auch mehr, leiten.

Zu Messzwecken ist es einerseits möglich, dass beispielsweise an einer Vorderseite oder einer sonstigen Stelle eines jeweiligen Testmoduls Messanschlüsse vorgesehen sind. Aber auch eine Messeinrichtung, die an Bord eines jeweiligen Testmoduls ist, ist vorteilhaft. Dann ist es nicht erforderlich, zusätzliche Messvorrichtungen mit der Testvorrichtung zu verbinden. Die Messeinrichtung gibt zweckmäßigerweise Messwerte an dem Steueranschluss aus. Auch bei der Messeinrichtung ist es vorteilhaft, wenn sie eine Eingangs-Pegelanpassungseinrichtung zur Anpassung von Messpegeln, die eingangsseitig an der Testanschlussanordnung anliegen, an einen niedrigeren Spannungs- und/oder Strompegel aufweist. Die Pegelanpassungseinrichtung ist vorzugsweise der jeweiligen Messeinrichtung vorgeschaltet. Es versteht sich, dass die Pegelanpassungseinrichtung auch beispielsweise den Anschlüssen für eine externe Messvorrichtung vorgeschaltet sein kann. Beispielsweise umfasst die Pegelanpassungseinrichtung einen Impedanzwandler.

Die Pegelanpassungseinrichtung senkt beispielsweise einen Messpegel, der eingangsseitig 30 Volt beträgt, auf einen Ausgangswert von maximal 10 Volt. Vorteilhaft ist es, wenn die Messeinrichtung auch einen Analog-Digital-Wandler umfasst.

Zwar wäre es möglich, die Testmodule beispielsweise mit einer Einzelverdrahtung miteinander zu verbinden. Vorteilhaft ist jedoch ein Bus-Konzept, bei dem die Testmodule einen Busankoppler für ihren jeweiligen Steueranschluss aufweisen. Der Steueranschluss bildet dann einen Busanschluss oder umfasst zumindest einen Busanschluss. Vorteilhaft ist beispielsweise ein EtherCAT-Busanschluss.

Mit dem Wahlschalter eines jeweiligen Testmoduls kann auch ein externer Sensor oder eine externe Last auf einen oder mehrere der Testanschlüsse der Testanschlussanordnung geschaltet werden. So sind beispielsweise bei einem jeweiligen Testmodul Extern-Anschlüsse für einen solchen externen Sensor oder eine externe Last vorhanden. Die externe Last ist beispielsweise eine Original-Last, beispielsweise eine Glühlampe oder dergleichen. Der externe Sensor ist vorzugsweise ein Originalsensor, der über das jeweilige Testmodul mit der zu testenden Komponente verbindbar ist. Die Testkomponente ist beispielsweise ein Steuergerät eines Kraftfahrzeuges.

Die externe Last kann aber auch ein Lastmodul umfassen, das für mehrere Testmodule bereitsteht. Dann ist vorteilhaft ein Sammelschienen-Konzept verwirklicht, bei dem mehrere Testmodule an eine Sammelschiene angeschlossen sind, die ihrerseits mit der Lastvorrichtung verbunden ist. Dann ist es vorzugsweise möglich, Sammelschienenkontakte der Testmodule mit Hilfe der jeweiligen Wahlschalter der Testmodule auf einen oder
mehrere Testanschlüsse der Testanschlussanordnungen zu schalten.

Das Sammelschienen-Konzept und Aufschalten über die jeweiligen Wahlschalter ist auch bei einer externen Vorgabeeinrichtung möglich, die an die Sammelschiene angeschlossen ist und Stimulationssignale, beispielsweise Sensorsignale, für eine Vielzahl von Testmodulen über die Sammelschiene bereitstellt.

Es versteht sich, dass eine solche Stimulations-Vorgabeeinrichtung auch an die Extern-Anschlüsse für eine externe Vorgabeeinrichtung eines jeweiligen Testmoduls, d.h. separat von Sammelschienenkontakten, anschließbar ist.

An der Sammelschiene können beispielsweise eine hohe Prüf-spannung, Prüfströme bis zu 20 Ampere und dergleichen mehr bereitgestellt werden.

Die Testvorrichtung hat vorzugsweise ein Gestell und/oder ein Gehäuse zur Aufnahme der Testmodule.

Vorteilhaft ist bei der Testvorrichtung ein modulares Steck-Konzept, bei dem die Testmodule als Steckmodule ausgestaltet sind, die an Steckplätzen der Steckvorrichtung steckbar sind. Dort sind beispielsweise der vorgenannte Busverbinder und/oder die Sammelschiene verfügbar, in die die Testmodule eingesteckt werden. Vorteilhaft ist es, wenn der Busverbinder auch eine Versorgungsspannung zum Betrieb der Testmodule bereitstellt.

Die Lasteinrichtung oder die Stimulationseinrichtung können auch durch auf das jeweilige Testmodul aufgesteckte Tochterplatinen oder Tochtermodule realisiert sein. So ist es beispielsweise möglich, wahlweise ein Widerstandsmodul, ein einstellbares Widerstandsmodul bzw. Potentiometermodul, einen Impulsgenerator, einen Schalter, eine Kapazität, eine Induktivität oder dergleichen an dem jeweiligen Steckplatz für das Tochtermodul beziehungsweise die Tochterplatine anzuordnen.

Der Wahlschalter enthält zweckmäßigerweise eine Schalteranordnung oder Schaltergruppe mit mehreren gemeinsam oder zumindest teilweise individuell einzeln schaltbaren Schaltern und/oder eine Schaltmatrix oder ist Bestandteil einer Schalteranordnung oder einer Schaltmatrix.

Nachfolgend werden Ausführungsbeispiele der Erfindung anhand der Zeichnung erläutert. Es zeigen:
- Figur 1: eine Vorderansicht einer erfindungsgemäßen Testvorrichtung mit Testmodulen,
- Figur 2: eine teilweise Ausschnittsvergrößerung der Testvorrichtung gemäß Figur 1 mit zwei Testmodulen, die an Rückwandplatinen angesteckt sind,
- Figur 3: eine schematische Ansicht beziehungsweise ein Schaltbild eines als Lastmodul ausgestalteten Testmoduls der Testvorrichtung gemäß Figur 1,
- Figur 4: eine schematische Ansicht beziehungsweise ein Schaltbild eines als Lastmodul ausgestalteten Testmoduls der Testvorrichtung gemäß Figur 1,
- Figur 5: ein Schaltbild eines Last- und Mess-Testmoduls mit vier Kanälen und
- Figur 6: ein Schaltbild beziehungsweise eine schematische Ansicht eines Stimulationstestmoduls mit vier Kanälen.

Eine Testanordnung 10 mit einer Testvorrichtung 11 dient zum Testen von elektrischen Komponenten 13a-13d eines Kraftfahrzeugs 12. Die Komponenten 13a-13d sind beispielsweise Steuergeräte, die über einen Kraftfahrzeug-Bus, zum Beispiel einen CAN-Bus, einen Flexray-Bus oder dergleichen, miteinander vernetzt sind. Somit bilden die Komponenten 13a-13d elektronische Komponenten.

In einem Gestell 15 der Testvorrichtung 11 sind Testmodule 16, 17, 18 und 19 an Steckplätzen 20 angeordnet. Die Testmodule 16 und 18 sind Last-Testmodule, die Testmodule 17, 19 Stimulations-Testmodule. Während die Testmodule 16 und 17 jeweils vier Test-Kanäle aufweisen, sind die Testmodule 18 und 19 nur mit jeweils einem Test-Kanal ausgestattet.

Die Testmodule 16-19 werden von einem Netzgerät 21, das ebenfalls am Gestell 15 angeordnet ist, mit elektrischer Versorgungsspannung versorgt. Ferner steht für die Testmodule 16-19 ein zentrales Stimulationsmodul 22 zur Verfügung, das Stimulationssignale für mehrere der Testmodule 16-19 bereitstellen kann. Ferner können die Last-Testmodule 16 auf ein zentrales Lastmodul 23 zurückgreifen, das für mehrere der Testmodule 16 eine elektrische, zweckmäßigerweise einstellbare Last bereitstellt.

Die Testvorrichtung 11 wird durch eine Steuerungseinrichtung 24 gesteuert, beispielsweise einen Personal Computer, ein Notebook oder dergleichen. Die Steuerungseinrichtung 24 ist ferner vorteilhaft mit dem Kraftfahrzeug-Bus 14 verbunden. Dafür steht beispielsweise ein nicht dargestelltes externes Koppelmodul und/oder eine Steckkarte 66 (z.B. PCI = Peripheral Component Interconnect oder PCMCIA = Personal Computer Memory Card International Association) bei der Steuerungseinrichtung 24 zur Verfügung. Somit kann die Steuerungseinrichtung 24 gleichzeitig auf den Kraftfahrzeug-Bus 14 zugreifen und beispielsweise den Datenverkehr auf dem Bus 14 protokollieren und analysieren und ferner durch Ansteuerung der Testmodule 16-19 elektrische Last- oder Stimulationsbedingungen für die zu testenden Komponenten 13a-13d einstellen. Dabei ist erfindungsgemäß ein Konzept realisiert, das einen einfachen Testaufbau und zugleich optimale Testmöglichkeiten bereitstellt.

Die Testmodule 16-19 haben wesentliche, für Testzwecke erforderliche Komponenten an Bord. Dadurch ist der Verkabelungsaufwand gering. Dennoch ist eine flexible Adaption an die jeweiligen Erfordernisse gut möglich.

Beispielsweise haben die Testmodule 16, 18 Wahlschalteranordnungen 25 mit Wahlschaltern 25a-25c und die Testmodule 17, 19 Wahlschalteranordnungen 26 mit Wahlschaltern 26a-26c. Über die Wahlschalteranordnungen 25, 26 sind Testanschlüsse 27a von Testanschlussanordnungen 27 beziehungsweise Testanschlüsse 28a-28d von Testanschlussanordnungen 28 wahlweise mit Lasteinrichtungen 29a der Testmodule 16 beziehungsweise Lasteinrichtungen 29b der Testmodule 18 oder Stimulationseinrichtungen 30a der Testmodule 17 beziehungsweise Stimulationseinrichtungen 30b der Testmodule 19 verbindbar.

Die Lasteinrichtungen 29a, 29b sowie die Stimulationseinrichtungen 30a, 30b sind an Bord der Testmodule 16-19 vorhanden. Mithin ist es also nicht notwendig, zur Erzeugung einer Last für die zu testenden Komponenten 13a-13d weitere Einrichtungen bereitzustellen. Mit Hilfe der Lasteinrichtungen 29a, 29b, die beispielsweise Widerstände, vorzugsweise regelbare Widerstände, mithin also Ohmsche Lasten umfassen, können Lastsituationen für die zu testenden Komponenten 13a-13d erzeugt werden. Dabei ist es beispielsweise möglich, dass eine höhere Last eingestellt wird, als später beim Normalbetrieb zu erwarten ist. Somit können beispielsweise Serienstreuungen, Störungen oder dergleichen bei den später anzuschließenden Original-Lasten in Zusammenhang mit den Komponenten 13a-13d auf einfache Weise getestet werden. Es versteht sich, dass die Lasteinrichtungen 29a, 29b nicht nur Ohmsche Lasten, sondern auch kapazitive und/oder induktive Lasten bereitstellen können.

Bei den Testmodulen 16 ist hierfür beispielsweise ein modulares Konzept verwirklicht, bei der die Lasteinrichtungen 29b als austauschbare Module ausgestaltet sind, beispielsweise in Gestalt eines Chips oder einer Tochterplatine. Die Lasteinrichtung 29b ist austauschbar an einer Platine 31 der Testmodule 16 befestigt.

Mit Hilfe der Stimulationseinrichtungen 30a, 30b können Stimulussignale 33 erzeugt werden, die mit den Wahlschalteranordnungen 25, 26 auf die Testanschlussanordnungen 28 schaltbar sind. Die Stimulussignale 33 stimulieren die zu testenden Komponenten 13a-13d. Beispielsweise sind die Stimulussignale 33 Stromsignale oder Spannungssignale, die das Verhalten eines Sensors, eines Eingangsschalters oder dergleichen simulieren, die beim späteren Betrieb an die Kraftfahrzeug-Komponenten 13a-13d angeschlossen sind. Somit können beispielsweise auch im realen Betrieb selten auftretende Betriebszustände, Störungen oder dergleichen durch die Testvorrichtung 11 für die Komponenten 13a-13d simuliert beziehungsweise stimuliert werden.

Während die Stimulationseinrichtung 30a fest auf dem Testmodul 19 montiert ist, beispielsweise durch einen oder mehrere elektronische Chips, ist die Stimulationseinrichtung 30b auswechselbar an den Testmödulen 17 befestigt. Beispielsweise ist die Stimulationseinrichtung 30b eine Tochterplatine, die auf eine Grund-Platine 32 der Testmodule 17 aufgesteckt ist.

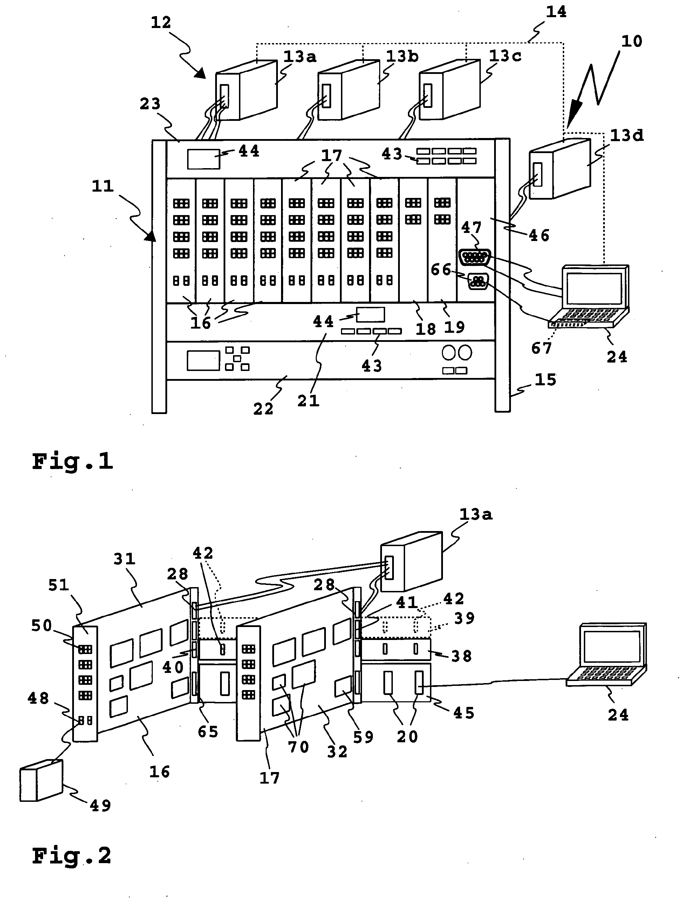

In Figur 2 sind nicht näher bezeichnete, auf den Platinen 31, 32 angeordnete Komponenten 70, z.B. ICs oder dergleichen, angedeutet.

Aber auch ein Testbetrieb der zu testenden Komponenten 13a-13d mit realen, beim späteren Betrieb des Kraftfahrzeugs 12 an die Komponenten 13a-13d angeschlossenen Bauteilen ist mit Hilfe der Testvorrichtung 11 leicht realisierbar.

Die Testmodule 16, 17 haben Extern-Anschlüsse 34a-34d, die Testmodule 18, 19 Extern-Anschlüsse 34, an die jeweils eine externe Einrichtung anschließbar ist, beispielsweise eine externe Last 35 oder eine externe Vorgabeeinrichtung 36. Die Extern-Anschlüsse 34, 34a-34d sind mit Hilfe der Wahlschalteranordnungen 25, 26 auf die Testanschlussanordnungen 27 aufschaltbar. Die externe Last 35 wird beispielsweise durch eine Original-Last, zum Beispiel eine Glühlampe oder eine sonstige Ohmsche Last, die Vorgabeeinrichtung 36 durch einen Sensor oder ein sonstiges Eingangssignal für die jeweils zu testende Komponente 13a-13d erzeugende Vorrichtung gebildet.

Ferner kann mit den Testmodulen 16-19 ein Kurzschluss an den Testanschlussanordnungen 27 hergestellt werden, sodass an Ein- oder Ausgängen der zu testenden Komponenten 13a-13d eine Kurzschluss-Situation einstellbar ist. Bei den Testmodulen 18, 19 bildet der Wahlschalter 25c jeweils einen Kurzschlussschalter. Bei den Testmodulen 16, 17 ist ein separater Kurzschlussschalter 37 vorgesehen, der über die Wahlschalteranordnungen 26 auf die Testanschlussanordnungen 28 schaltbar ist. Selbstverständlich könnte der Kurzschlussschalter 37 auch ein Bestandteil einer Wahlschalteranordnung in der Art der Wahlschalteranordnung 26 sein. Zweckmäßigerweise wird zunächst der Kurzschlussschalter 37 angewählt und erst dann der Kurzschluss durch das Schließen des Kurzschlussschalters 37 herbeigeführt. Die Strombelastbarkeit des separaten Kurzschlussschalters 37 ist beispielsweise höher als die Belastbarkeit der Wahlschalteranordnungen 25 und/oder 26.

Die Wahlschalteranordnungen 25 der Testmodule 18, 19 ermöglichen ein Umschalten zwischen den Lasteinrichtungen 29a oder Stimulationseinrichtungen 30a und den Extern-Anschlüssen 34 sowie wahlweise das Erzeugen eines Kurzschlusses. Eine zusätzliche Wahlmöglichkeit bieten die Wahlschalteranordnungen 26 der Testmodule 16, 17. Mit den Wahlschalteranordnungen 26 können nämlich beispielsweise auch elektrische Verbindungen zu den zentralen Stimulations- und Lastmodulen 22, 23 hergestellt werden. Zwar wäre es prinzipiell denkbar, die Module 22, 23 über Einzeldrahtverbindungen beispielsweise an der Rückwand der Testvorrichtung 11, mit den jeweiligen Testmodulen 16 und 17 zu verbinden. Bei der Testvorrichtung 11 ist jedoch ein einfach bedienbares, komfortables Konzept gewählt: Die Module 22, 23 sind mit einer Sammelschiene 38 und vorteilhaft mit einer optional vorgesehenen zweiten Sammelschiene 39 verbunden. Die Testmodule 16, 17 können an den Steckplätzen 20 mit den Sammelschienen 38 und 39 verbunden werden, wobei Sammelschienenkontakte 40, 41 der Testmodule 16, 17 mit korrespondierenden Kontakten 42 an den beispielsweise als Rückwandplatinen ausgestalteten Sammelschienen 38 und 39 in Verbindung treten. Mit den Wahlschalteranordnungen 25, 26 sind Verbindungen von den Sammelschienenkontakten 40, 41 auf die Testanschlussanordnungen 28 schaltbar.

Mit dem zentralen Stimulationsmodul 22 können Stimulationssignale erzeugt werden, beispielsweise Pulsspannungen, Wechselspannungen oder dergleichen. Das zentrale Lastmodul 22 stellt vorzugsweise höhere Lasten oder anders gestaltete Lasten als die internen Lasteinrichtungen 29a, 29b zur Verfügung, beispielsweise eine kapazitive oder induktive Last. Das zentrale Lastmodul 23 ist beispielsweise eine elektronische Last. Über Eingabeschalter 43 sowie ein Display 44 sind Stimulations- oder Lastwerte bei den Zentral-Modulen 22, 23 einstellbar.

Das Rückwand-Vernetzungskonzept ist bei den Testmodulen 16-19 konsequent fortgesetzt. Sie sind mit ihren Steueranschlusskontakten 65 an eine Kommunikations- und/oder Steuerrückwand 45, z.B. eine Bus-Rückwand, angesteckt, die zur Verbindung mit der Steuerungseinrichtung 24 dient. Die Steuerrückwand 45 könnte beispielsweise eine Parallel-Verbindung mit der Steuerungseinrichtung 24 realisieren, wobei beispielsweise dediziert jeweils eine oder mehrere Leitungen zwischen dem jeweiligen Testmodul 16-19 und der Steuerungseinrichtung 24 bereitstehen. Vorliegend ist jedoch ein Buskonzept, vorzugsweise serielles Buskonzept, realisiert, beispielsweise ein EtherCAT-Bus. In der teilweise schematischen Darstellung gemäß Figur 2 ist die Steuerungseinrichtung 24 unmittelbar mit der Steuerrückwand 45 verbunden, z.B. mit einem Bus 63 der Steuerrückwand 45. Zweckmäßigerweise ist jedoch ein Schnittstellenmodul 46 vorgesehen, das an einem der Steckplätze 20 in die Steuerrückwand 45 eingesteckt ist. An der Vorderseite des Schnittstellenmoduls 46 ist eine Schnittstelle 47, beispielsweise eine EtherCAT-Schnittstelle, eine serielle Schnittstelle (z.B. RS 232) oder dergleichen, zur Verbindung mit der Steuerungseinrichtung 24 vorgesehen. Somit kann die Steuerungseinrichtung 24 zweckmäßigerweise frontseitig mit der Testvorrichtung 11 verbunden werden.

Während die Testanschlussanordnungen 27, 28 an der Rückseite der Testvorrichtung 11 angeordnet sind, sodass etwaige Verdrahtungen mit den zu testenden Komponenten 13a-13d beim Testbetrieb nicht stören und die Bedienkomponenten der Testvorrichtung 11 vorderseitig bequem und nicht durch Kabel verdeckt zugänglich sind, sind weitere Anzeige- und Kontaktvorrichtungen an der Frontseite der Testvorrichtung 11 vorhanden, beispielsweise mit den Testanschlussanordnungen 28 gekoppelte Messanschlüsse 48, in die eine externe Messvorrichtung 49, zum Beispiel ein Oszilloskop, eingesteckt werden kann. Ferner sind an der Frontseite der Testmodule 16, 17 Anzeigemittel 50, beispielsweise LEDs, vorgesehen, die Betriebszustände, Steckerbelegungen, Vorhandensein von Schwellwert-Spannungen oder dergleichen signalisieren können. Die Messanschlüsse 48 und die Anzeigemittel 50 sind an Frontwänden 51 der Testmodule 16, 17 angeordnet.

Es ist allerdings nicht unbedingt notwendig, dass man eine externe Messvorrichtung, zum Beispiel die Messvorrichtung 49, zu Messzwecken an die Testvorrichtung 11 ankoppelt. Es sind nämlich auch interne Messmittel bei der Testvorrichtung 11 vorhanden. Die Testmodule 16 und 18 weisen nämlich interne Messeinrichtungen 52 zur Messung von an den Testanschlussanordnungen 27 oder 28 anliegenden Signalen 53 und zur anschließenden Ausgabe der Messwerte, die anhand der Signale 53 gebildet sind, über Steueranschlüsse 54 der Testmodule 16 und 18 auf. Auch die Testmodule 17 und 19 verfügen über Steueranschlüsse 54. Die Messeinrichtungen 52 können zusätzliche Komponenten umfassen, beispielsweise beim Testmodul 18 eine Pegelanpassungseinrichtung 55 eines an dem Testanschluss 27a anliegenden höheren Spannungs- oder Strompegels auf einen niedrigeren Spannungs- oder Strompegel, der beispielsweise durch einen Operationsverstärker verarbeitbar ist. Bei der Messeinrichtung 52 des Testmoduls 16 ist ferner ein Analog-Digital-Wandler 57 vorgesehen, der Ausgangssignale beziehungsweise Messsignale eines Operationsverstärkers 56 in digitale Messwerte wandelt, der Eingangssignale von der Testanschlussanordnung 28 erhält.

Beim Ausführungsbeispiel haben nur die beiden Last-Testmodule 16, 18 Messeinrichtungen. Es versteht sich, dass auch Last-Testmodule ohne interne Messeinrichtung im Rahmen der Erfindung möglich sind oder dass auch Stimulus-Testmodule Messeinrichtungen an Bord haben.

Ferner ist es möglich, dass kombinierte Last- und Stimulationsmodule realisiert werden.

Bei all diesen Bauvarianten einschließlich der Variante des Ausführungsbeispiels ist es vorteilhaft, wenn der jeweilige Steueranschluss, beispielsweise der Steueranschluss 54, als ein Busanschluss realisiert ist. Hierfür weisen die Testmodule 16-19 beispielsweise Busankoppler 58 auf, vorliegend zum Beispiel EtherCAT-Busankoppler.

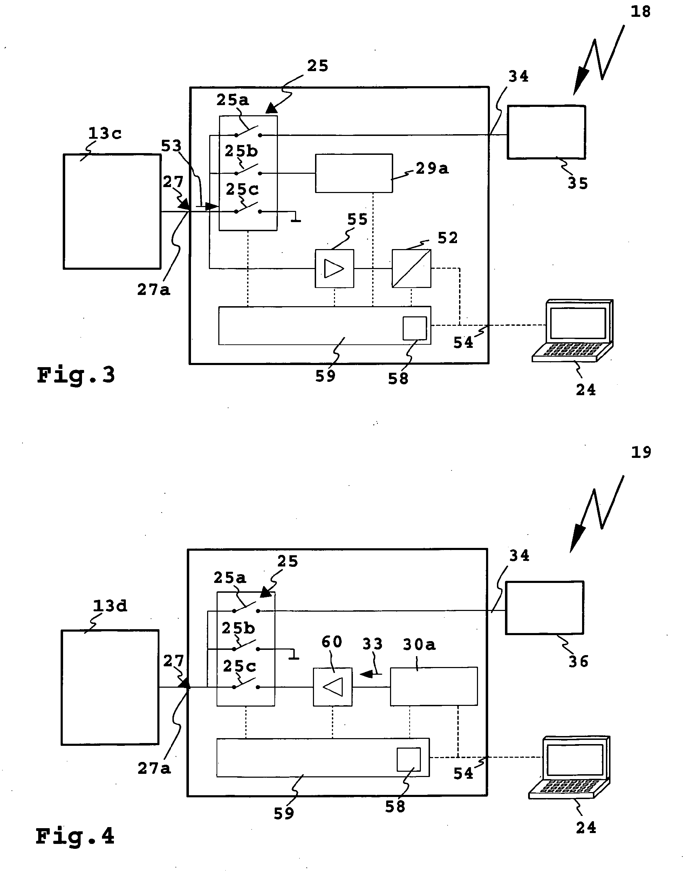

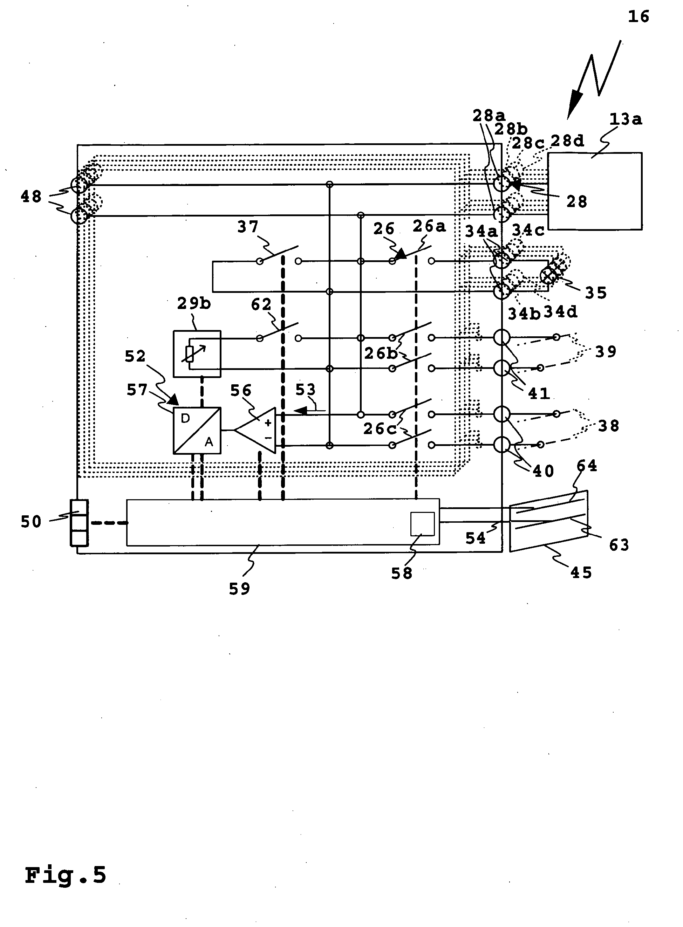

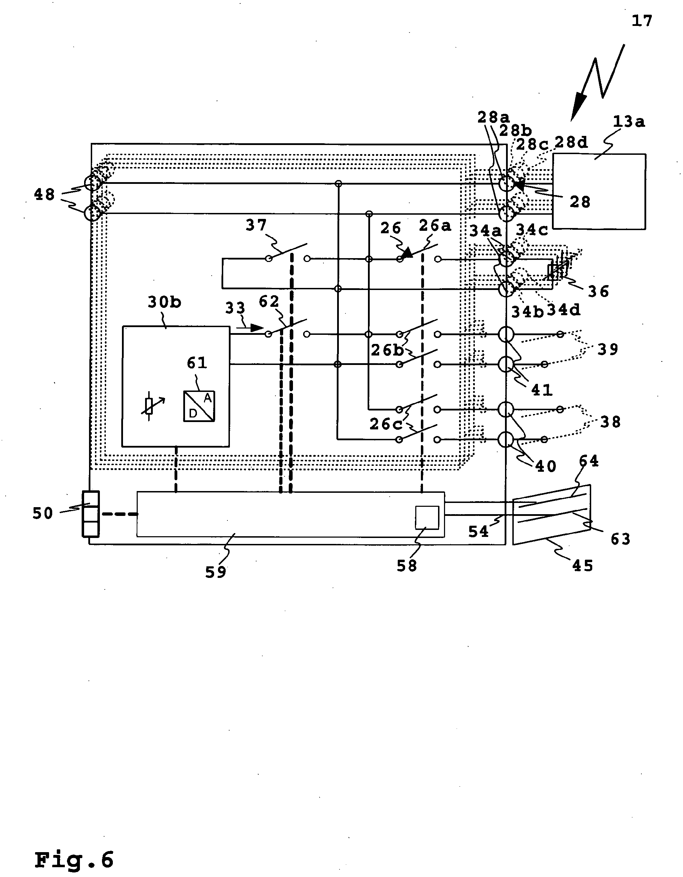

Die Busankoppler 58 sind bei den Testmodulen 16-19 Bestandteile lokaler Steuerungen 59 an Bord der Testmodule 16-19. Es versteht sich, dass die Busankoppler 58 auch als separate Komponenten, beispielsweise spezielle Chips, realisiert sein können. Die lokalen Steuerungen 59, die beispielsweise Mikrocontroller umfassen, steuern die Funktionen der Testmodule 16-19. Beispielsweise steuern die Steuerungen 59 anhand von Steuersignalen, die die Steuerungseinrichtung 24 sendet, die Wahlschalteranordnungen 25, 26 an. Ferner ist es vorteilhaft, wenn die lokalen Steuerungen 59 weitere Funktionen der Testmodule 16-19 steuern, beispielsweise die Lasteinrichtungen 29a, 29b und die Stimulationseinrichtungen 30a, 30b ansteuern. Die Steuerfunktionen der lokalen Steuerungen 59 sind durch gestrichelte Linien in den Figuren 3-6 angedeutet.

Wie bei den lokalen Messeinrichtungen 52 sind auch bei den lokalen, an Bord der Testmodule 16-19 vorhandenen weiteren Einrichtungen Pegelanpassungseinrichtungen sowie Analog-Digital-Wandler oder Digital-Analog-Wandler zweckmäßig. So weist beispielsweise die Stimulationseinrichtung 30a eine Ausgabe-Pegelanpassungseinrichtung 60 auf, die das Stimulussignal 33 von einem niedrigen auf einen höheren Spannungs- oder Strompegel anhebt. Die Stimulationseinrichtung 30b hat einen Digital-Analog-Wandler 61, der von der Steuerung 59 vorgegebene Digitalwerte in analoge Ausgabewerte wandelt.

Die Messeinrichtung 52 der Testmodule 16 ist mit Hilfe eines Schalters 62, der durch die Steuerung 59 betätigbar ist, ein- und ausschaltbar.

Zweckmäßigerweise werden die Testmodule 16-19 über die Steuerrückwand 45 oder eine sonstige Rückwand an der Testvorrichtung mit elektrischer Versorgungsspannung versorgt, die das Netzgerät 21 bereitstellt. Hierfür ist beispielsweise eine Versorgungsleitung 64 an der Steuerrückwand 45 vorgesehen.

Im Rahmen der Erfindung sind ein- oder mehrkanalige Testmodule ohne weiteres realisierbar. So haben die Testmodule 18 und 19 beispielsweise nur einen einzigen Test-Kanal zum Anschluss einer zu testenden elektrischen Komponente, während die Testmodule 16 und 17 jeweils vier Test-Kanäle aufweisen. Zur Vereinfachung der zeichnerischen Darstellung ist jedoch nur der erste Test-Kanal, der in der Regel den Index a hat, dargestellt, während die weiteren Test-Kanäle in gestrichelten Linien angedeutet sind. Es versteht sich, dass für die Testkanäle mit den Indizes b, c und d weitere Funktionselemente vorhanden sind.

Die Wahlschalteranordnungen 26 sind beispielsweise zweckmäßigerweise matrixartig und/oder enthalten eine Gruppe einzeln oder gruppenweise zusammen schaltbarer Wahlschalter 26a, 26b, 26c.

Vorteilhaft ist es, wenn eine einzige Steuerung 59 mehrere Test- oder Mess-Kanäle eines Testmoduls steuert.

An dem Schnittstellenmodul 46 ist ferner vorteilhaft eine Bus-Schnittstelle 66, z.B. eine CAN-Busschnittstelle, zur Verbindung der Steuerungseinrichtung 24, z.B. des Busmoduls 66, mit dem Kraftfahrzeug-Bus 14 oder mit einer entsprechenden Busschnittstelle der Komponenten 13a-13d vorgesehen. Die Verbindung zwischen der Bus-Schnittstelle 66 und den Testanschlussanordnungen 27 und/oder 28 kann vorzugsweise über die jeweilige Wahlschalteranordnung 25 oder 26 geschaltet werden.

## Patentansprüche

1. Testvorrichtung für elektrische, insbesondere elektronische, Komponenten (13a-13d), insbesondere eines Kraftfahrzeugs (12), mit Testmodulen (16-19), die eine Testanschlussanordnung (27, 28) zum Anschließen einer zu testenden elektrischen Komponente (13a-13d), einen Steueranschluss (54) zum Anschluss einer zentralen Steuerung und mindestens einen über den Steueranschluss (54) betätigbaren Wahlschalter (25a-25c, 26a-26c) zum wahlweisen Aufschalten mindestens einer Last und/oder mindestens eines Stimulussignals (33) auf Testanschlüsse (27a, 28a-28d) der Testanschlussanordnung (27, 28) aufweisen, wobei mindestens ein Testmodul (16-19) eine interne, über den mindestens einen Wahlschalter (25a-25c, 26a-26c) mit der Testanschlussanordnung (27, 28) verbindbare Stimulationseinrichtung (30a, 30b) zur Erzeugung mindestens eines Stimulussignals (33) und/oder eine interne, über den mindestens einen Wahlschalter (25a-25c, 26a-26c) mit der Testanschlussanordnung (27, 28) verbindbare Lasteinrichtung zur Bildung der an die Testanschlussanordnung (27, 28) anzulegenden Last an Bord hat, **dadurch gekennzeichnet, dass** mindestens ein Testmodul (16-19) einen Anschluss (34a-34d) zum Anschließen einer externen Vorgabeeinrichtung (36), insbesondere eines externen Sensors, und/oder einer externen Last (35) aufweist, wobei die externe Vorgabeeinrichtung oder die externe Last (35) über den mindestens einen Wahlschalter (25a-25c, 26a-26c) auf einen Testanschluss der Testanschlussanordnung (27, 28) schaltbar sind.

2. Testvorrichtung nach Anspruch 1, **dadurch gekennzeichnet, dass** die Stimulationseinrichtung (30a, 30b) über den Steueranschluss (54) zur Einstellung des mindestens einen Stimulussignals (33) steuerbar ist.

3. Testvorrichtung nach Anspruch 1 oder 2, **dadurch gekennzeichnet, dass** die Stimulationseinrichtung (30a, 30b) eine Ausgabe-Pegelanpassungseinrichtung (60) zum Anpassen des mindestens einen Stimulussignals (33) von einem ersten, insbesondere niedrigeren, Spannungs- und/oder Strompegel auf einen zweiten, insbesondere höheren, Spannungs- oder Strompegel aufweist.

4. Testvorrichtung nach einem der vorhergehenden Ansprüche, **dadurch gekennzeichnet, dass** die Stimulationseinrichtung (30a, 30b) einen Digital-Analog-Wandler (61) umfasst.

5. Testvorrichtung nach einem der vorhergehenden Ansprüche, **dadurch gekennzeichnet, dass** mindestens ein Testmodul (16-19) einen Kurzschlussschalter (25c, 37) zum Erzeugen eines Kurzschlusses an der Testanschlussanordnung (27, 28) aufweist.

6. Testvorrichtung nach einem der vorhergehenden Ansprüche, **dadurch gekennzeichnet, dass** mindestens ein Testmodul (16-19) eine Messeinrichtung (52) zur Messung eines an der Testanschlussanordnung (27, 28) anliegenden Signals (53) und zur Ausgabe an dem Steueranschluss (54) an Bord hat.

7. Testvorrichtung nach Anspruch 6, **dadurch gekennzeichnet, dass** die Messeinrichtung (52) eine Eingangs-Pegelanpassungseinrichtung (55) zum Anpassen eines an der Testanschlussanordnung (27, 28) anliegenden ersten, insbesondere höheren, Spannungs- oder Strompegel auf einen zweiten, insbesondere niedrigeren, Spannungs- und/oder Strompegel aufweist.

8. Testvorrichtung nach Anspruch 6 oder 7, **dadurch gekennzeichnet, dass** die Messeinrichtung (52) einen Analog-Digital-Wandler (57) umfasst.

9. Testvorrichtung nach einem der vorhergehenden Ansprüche, **dadurch gekennzeichnet, dass** mindestens ein Teil der Testmodule (16-19) einen Busankoppler (58) für den Steueranschluss (54) aufweist, und dass der Steueranschluss (54) einen Busanschluss umfasst oder als Busanschluss ausgestaltet ist.

10. Testvorrichtung nach einem der vorhergehenden Ansprüche, **dadurch gekennzeichnet, dass** mindestens ein Testmodul (16-19) einen Anschluss (48) zum Anschließen einer externen Messvorrichtung (49) aufweist.

11. Testvorrichtung nach einem der vorhergehenden Ansprüche, **dadurch gekennzeichnet, dass** die Testmodule (16-19) als Steckmodule ausgestaltet sind, und dass die Testvorrichtung (11) Steckplätze (20) zum Stecken der Testmodule (16-19) aufweist.

12. Testvorrichtung nach einem der vorhergehenden Ansprüche, **dadurch gekennzeichnet, dass** die Testvorrichtung (11) eine Sammelschiene (38, 39) zur Bereitstellung mindestens eines Stimulussignals (33) und/oder einer Prüf-Spannung und/oder eines Prüf-Stroms und/oder einer Prüflast für die Testmodule (16-19) umfasst, und dass zumindest eine Leitung der Sammelschiene (38, 39) über den jeweiligen Wahlschalter (25a-25c, 26a-26c) der Testmodule (16-19) auf die Testanschlussanordnung (27, 28) schaltbar ist.

13. Testvorrichtung nach Anspruch 12, **dadurch gekennzeichnet, dass** die Sammelschiene (38, 39) und/oder ein Verbinder zum Verbinden der Testmodule (16-19), insbesondere zu Kommunikationszwecken, an einer Rückwand der Testvorrichtung (11) angeordnet ist.

14. Testvorrichtung nach einem der vorhergehenden Ansprüche, **dadurch gekennzeichnet, dass** die Stimulationseinrichtung (30b) oder die Lasteinrichtung (29b) auf einer auf das jeweilige Testmodul (16-19) aufgesteckten Tochterplatine angeordnet ist.

## Claims

1. Testing device for electric, in particular electronic, components (13a-13d), in particular of a motor vehicle (12), with testing modules (16-19) comprising a testing port assembly (27, 28) for connecting an electric component (13a-13d) to be tested, a control port (54) for connecting a central control unit and at least one selector (25a-25c, 26a-26c) actuable via the control port (54) for optionally offering at least one load and/or at least one stimulus signal (33) to testing ports (27a, 28a-28d) of the testing port assembly (27, 28), wherein at least one testing module (16-19) has an internal simulation device (30a, 30b) connectable to the testing port assembly (27, 28) via the at least one selector (25a-25c, 26a-26c) for generating at least one stimulus signal (33) and/or an internal load device connectable to the testing port assembly (27, 28) via the at least one selector (25a-25c, 26a-26c) for forming the load to be applied to the testing port assembly (27, 28), **characterised in that** at least one testing module (16-19) has a port (34a-34d) for connecting an external presetting device (36), in particular an external sensor and/or an external load (35), wherein the external presetting device or the external load (35) can be offered to a testing port of the testing port assembly (27, 28).

2. Testing device according to claim 1, **characterised in that** the simulation device (30a, 30b) can be controlled via the control port (54) for adjusting the at least one stimulus signal (33).

3. Testing device according to claim 1 or 2, **characterised in that** the simulation device (30a, 30b) has an output level adaptation device (60) for adapting the at least one stimulus signal (33) from a first, in particular lower, voltage and/or current level to a second, in particular higher, voltage and/or current level.

4. Testing device according to any of the preceding claims, **characterised in that** the simulation device (30a, 30b) comprises an digital-to-analogue converter (61).

5. Testing device according to any of the preceding claims, **characterised in that** at least one testing module (16-19) has a short-circuiting switch (25c, 37) for generating a short-circuit at the testing port assembly (27, 28).

6. Testing device according to any of the preceding claims, **characterised in that** at least one testing module (16-19) has a measuring device (52) on board for measuring a signal (53) applied to the testing port assembly (27, 28) and for outputting to the control port (54).

7. Testing device according to claim 6, **characterised in that** the measuring device (52) has an input level adaptation device (55) for adapting a first, in particular higher, voltage or current level applied to the testing port assembly (27, 28) to a second, in particular lower, voltage and/or current level.

8. Testing device according to claim 6 or 7, **characterised in that** the measuring device (52) comprises an analogue-to-digital converter (57).

9. Testing device according to any of the preceding claims, **characterised in that** at least a part of the testing modules (16-19) has a bus coupler (58) for the control port (54), and **in that** the control port (54) comprises or is designed as a bus connection.

10. Testing device according to any of the preceding claims, **characterised in that** at least one testing module (16-19) has a port (48) for connecting an external measuring device (49).

11. Testing device according to any of the preceding claims, **characterised in that** the testing modules (16-19) are designed as plug-in modules and the testing device (11) has plug-in locations (20) for plugging in the testing modules (16-19).

12. Testing device according to any of the preceding claims, **characterised in that** the testing device (11) comprises a bus bar (38, 39) for providing at least one stimulus signal (33) and/or a testing voltage and/or a testing current and/or a testing load for the testing modules (16-19), and **in that** at least one line of the bus bar (38, 39) can be offered to the testing port assembly (27, 28) via the respective selector (25a-25c, 26a-26c) of the testing modules (16-19).

13. Testing device according to claim 12, **characterised in that** the bus bar (38, 39) and/or a connector for connecting the testing modules (16-19), in particular for communication purposes, is/are located at a rear wall of the testing device (11).

14. Testing device according to any of the preceding claims, **characterised in that** the simulation device (30b) or the load device (29b) is located on a daughter board plugged onto the respective testing module (16-19).

## Revendications

1. Dispositif de test pour composants (13a-13d) électriques, en particulier électroniques, en particulier d'un véhicule automobile (12), avec des modules de test (16-19), qui présentent un ensemble de raccordement de test (27, 28) servant à raccorder un composant (13a-13d) électrique à tester, un raccord de commande (54) servant à raccorder une commande centrale et au moins un sélecteur (25a-25c, 26a-26c) pouvant être actionné par l'intermédiaire du raccordement de commande (54) servant à activer sélectivement au moins une charge et/ou au moins un signal de stimulus (33) sur des raccordements de test (27a, 28a-28d) de l'ensemble de raccordement de test (27, 28), dans lequel au moins un module de test (16-19) a à son bord un système de stimulation (30a, 30b) interne pouvant être connecté à l'ensemble de raccordement de test (27, 28) par l'intermédiaire de l'au moins un sélecteur (25a-25c, 26a-26c), servant à générer au moins un signal de stimulus (33) et/ou un système de charge interne pouvant être connecté à l'ensemble de raccordement de test (27, 28) par l'intermédiaire de l'au moins un sélecteur (25a-25c, 26ab-26c), servant à former la charge à appliquer au niveau de l'ensemble de raccordement de test (27, 28), **caractérisé en ce qu'**au moins un module de test (16-19) présente un raccordement (34a-34d) servant à raccorder un système de spécification (36) externe, en particulier un capteur externe et/ou une charge (35) externe, dans lequel le système de spécification externe ou la charge (35) externe peuvent être commutés sur un raccordement de test de l'ensemble de raccordement de test (27, 28) par l'intermédiaire de l'au moins un sélecteur (25a-25c, 26a-26c)

2. Dispositif de test selon la revendication 1, **caractérisé en ce que** le système de stimulation (30a, 30b) peut être commandé par l'intermédiaire du raccordement de commande (54) pour régler l'au moins un signal de stimulus (33).

3. Dispositif de test selon la revendication 1 ou 2, **caractérisé en ce que** le système de stimulation (30a, 30b) présente un système d'adaptation de niveau d'émission (60) servant à adapter l'au moins un signal de stimulus (33) d'un premier niveau de tension et/ou de courant, en particulier plus bas, sur un deuxième niveau de tension ou de courant, en particulier plus élevé.

4. Dispositif de test selon l'une quelconque des revendications précédentes, **caractérisé en ce que** le système de stimulation (30a, 30b) comprend un convertisseur numérique-analogique (61).

5. Dispositif de test selon l'une quelconque des revendications précédentes, **caractérisé en ce qu'**au moins un module de test (16-19) présente un commutateur de court-circuit (25c, 37) servant à générer un court-circuit au niveau de l'ensemble de raccordement de test (27, 28).

6. Dispositif de test selon l'une quelconque des revendications précédentes, **caractérisé en ce qu'**au moins un module de test (16-19) a à son bord un système de mesure (52) servant à mesurer un signal (53) appliqué au niveau de l'ensemble de raccordement de test (27, 28) et servant à émettre au niveau du raccordement de commande (54).

7. Dispositif de test selon la revendication 6, **caractérisé en ce que** le système de mesure (52) présente un système d'adaptation de niveau d'entrée (55) servant à adapter un premier niveau de tension ou de courant, en particulier plus élevé, appliqué au niveau de l'ensemble de raccordement de test (27, 28) sur un deuxième niveau de tension et/ou de courant, en particulier plus bas.

8. Dispositif de test selon la revendication 6 ou 7, **caractérisé en ce que** le système de mesure (52) comprend un convertisseur analogique-numérique (57).

9. Dispositif de test selon l'une quelconque des revendications précédentes, **caractérisé en ce qu'**au moins une partie des modules de test (16-19) présente un coupleur de bus (58) pour le raccordement de commande (54), et **en ce que** le raccordement de commande (54) comprend un raccordement de bus ou est configuré sous la forme d'un raccordement de bus.

10. Dispositif de test selon l'une quelconque des revendications précédentes, **caractérisé en ce qu'**au moins un module de test (16-19) présente un raccordement (48) servant à raccorder un dispositif de mesure (49) externe.

11. Dispositif de test selon l'une quelconque des revendications précédentes, **caractérisé en ce que** les modules de test (16-19) sont configurés sous la forme de modules enfichables, et **en ce que** le dispositif de test (11) présente des emplacements d'enfichage (20) servant à enficher les modules de test (16-19).

12. Dispositif de test selon l'une quelconque des revendications précédentes, **caractérisé en ce que** le dispositif de test (11) comprend un rail collecteur (38, 39) servant à fournir au moins un signal de stimulus (33) et/ou une tension d'essai et/ou un courant d'essai et/ou une charge d'essai pour les modules de test (16-19), et qu'au moins une ligne du rail collecteur (38, 39) peut être commutée sur l'ensemble de raccordement de test (27, 28) par l'intermédiaire du sélecteur (25a-25c, 26a-26c) respectif des modules de test (16-19).

13. Dispositif de test selon la revendication 12, **caractérisé en ce que** le rail collecteur (38, 39) et/ou un connecteur servant à connecter les modules de test (16-19), en particulier à des fins de communication, est disposé au niveau d'une paroi arrière du dispositif de test (11).

14. Dispositif de test selon l'une quelconque des revendications précédentes, **caractérisé en ce que** le système de stimulation (30b) ou le système de charge (29b) est disposé sur une carte fille enfichée sur le module de test (16-19) respectif.
